Europäisches Patentamt

**European Patent Office**

**Office européen des brevets**

(11) Numéro de publication: **0 307 432 B1**

(12) **FASCICULE DE BREVET EUROPEEN**

(45) Date de publication de fascicule du brevet: **21.10.92** (51) Int. Cl.⁵: **H01F 7/02**

(21) Numéro de dépôt: **88902491.5**

(22) Date de dépôt: **02.03.88**

(86) Numéro de dépôt internationale :
**PCT/FR88/00116**

(87) Numéro de publication internationale :
**WO 88/06798 (07.09.88 88/20)**

(54) **SYSTEME D'AIMANTS PERMANENTS POUR UN CHAMP MAGNETIOUE INTENSE.**

(30) Priorité: **03.03.87 FR 8702851**

(43) Date de publication de la demande:
**22.03.89 Bulletin 89/12**

(45) Mention de la délivrance du brevet:
**21.10.92 Bulletin 92/43**

(84) Etats contractants désignés:
**DE GB IT NL**

(56) Documents cités:
**EP-A- 0 161 782**
**EP-A- 0 170 318**
**DE-A- 1 464 656**
**FR-A- 2 168 233**

(73) Titulaire: **COMMISSARIAT A L'ENERGIE ATO-MIOUE Etablissement de Caractère Scientifique Technique et Industriel**
**31/33, rue de la Fédération**
**F-75015 Paris(FR)**

(72) Inventeur: **CHAILLOUT, Jean-Jacques**
**Lotissement "Le Montagnier Haut"**
**F-38960 Saint-Etienne-de-Crossey(FR)**
Inventeur: **JEANDEY, Christian**
**Chemin Fiancey, Ouartier du Muret**
**F-38120 Saint-Egrève(FR)**
Inventeur: **TOURNIER, Edmond**
**2, place Docteur-Léon-Martin**
**F-38000 Grenoble(FR)**

(74) Mandataire: **Mongrédien, André et al**
**c/o BREVATOME 25, rue de Ponthieu**
**F-75008 Paris(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

## Description

La présente invention se rapporte à un système d'aimants permanents pour créer un champ magnétique intense nécessaire par exemple en imagerie par résonance magnétique.

Plusieurs types d'aimants ont été déjà employés dans ce but. Les aimants résistifs présentent l'inconvénient de dégager de grandes quantités de chaleur (plusieurs dizaines de kilowatts pour des champs de quelques dixièmes de teslas) et sont actuellement pratiquement abandonnés pour cette raison. Les aimants à supraconducteurs, très utilisés, nécessitent cependant un équipement coûteux gros consommateur d'hélium liquide.

Dans les conceptions impliquant des circuits magnétiques par aimants permanents, le principal problème concerne l'intensité du champ. Le brevet européen EP-A-0 161 782 propose de combiner en particulier deux aimants principaux de part et d'autre d'un entrefer et dont les faces en regard sont de polarités opposées, deux pièces polaires en matériau magnétique sur ces faces, et une culasse magnétique entourant l'ensemble. Les lignes de champ magnétique passent par les deux aimants principaux, parcourent l'entrefer et se referment en passant par la culasse qui empêche ainsi la déperdition d'énergie magnétique dans le milieu extérieur.

Cette solution est très pesante et implique en particulier une grande quantité de matériaux spéciaux et coûteux. De plus, une partie des lignes de champ passant par la périphérie des pièces polaires aboutissent directement à des zones voisines de la culasse et contrarient l'homogénéité du champ magnétique dans l'entrefer qu'il est pourtant indispensable de réaliser. A partir de cette constatation, le brevet indique plusieurs moyens de rectifier ces lignes de champ, mais qui nécessitent une nouvelle augmentation de la quantité de matière ferromagnétique.

Le brevet européen EP-A-0 170 318 mentionne l'emploi d'aimants latéraux additionnels qui referment l'entrefer et dont les sens d'aimantation sont opposés à ceux des aimants permanents principaux.

Cette disposition permet d'accroître l'intensité et l'homogénéité du champ magnétique dans l'entrefer, mais le texte de ce brevet ne décrit que des configurations pour lesquelles les aimants permanents principaux et les aimants additionnels latéraux sont en contact par des arêtes ou même légèrement écartés. Il en résulte que l'homogénéité et l'intensité du champ magnétique créé laissent encore à désirer.

L'invention décrite ici permet de satisfaire l'exigence d'un champ magnétique intense avec un circuit magnétique comprenant une quantité modérée de matière et permet également d'obtenir une bonne homogénéité du champ magnétique à l'intérieur de l'entrefer.

A cet effet, on propose que les aimants permanents additionnels, de part et d'autre de l'entrefer, s'étendent au moins partiellement en regard des aimants permanents principaux et des pièces polaires qui les recouvrent.

Il est très intéressant de prévoir que les aimants additionnels s'étendent également au-delà des pièces polaires vers l'extérieur de l'entrefer ; de même pour les aimants principaux.

L'homogénéité du champ magnétique dans l'entrefer peut être renforcée si on peut régler la position des aimants additionnels de façon à modifier leur écartement ou leur distance des pièces polaires.

Plus précisément, l'invention concerne un système d'aimants permanents comportant une culasse perméable magnétique formée de deux parois de support opposées et reliées par deux parois de liaison, deux aimants permanents principaux de même sens d'aimantation disposés sur les parois de support à l'intérieur de la culasse et dont des surfaces en regard portent des pôles opposés, deux plaques perméables magnétiques sur les surfaces en regard et qui délimitent un entrefer, deux aimants permanents latéraux de sens d'aimantation opposé à celui des aimants permanents principaux, qui délimitent également l'entrefer et qui sont disposés en face des parois de liaison et à l'intérieur de la culasse, caractérisé en ce que les aimants permanents latéraux s'étendent latéralement entre les plaques perméables magnétiques de façon à venir en regard des bords latéraux des aimants permanents principaux et des plaques perméables magnétiques, et en ce que les aimants permanents principaux débordent des plaques.

On décrit à présent une réalisation concrète de l'invention à l'aide des figures suivantes, données en annexe à titre illustratif :
- la figure 1 est une vue de face de l'invention,
- la figure 2 est une coupe suivant la ligne II-II de la figure 1, et
- la figure 3 est un graphique illustrant certains avantages de l'invention.

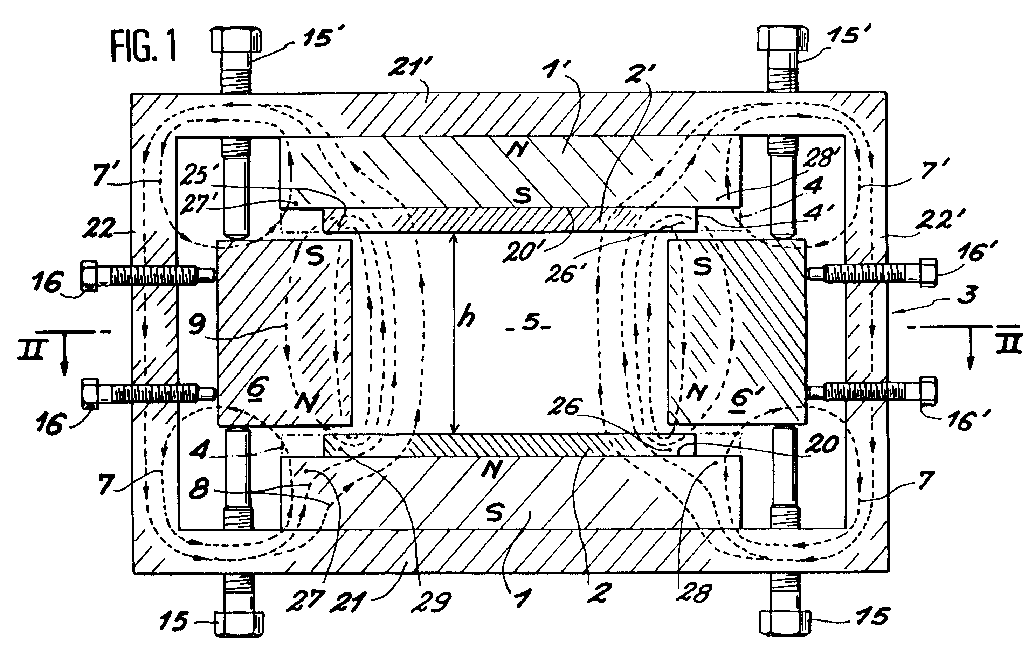

La figure 1 représente tout d'abord des composants déjà utilisés dans l'art antérieur : deux aimants permanents principaux 1 et 1' disposés face à face, de part et d'autre d'un entrefer 5, et de même sens d'aimantation, de telle sorte que les lignes de champ magnétique parcourent l'entrefer 5 d'un aimant permanent principal 1 à l'autre 1'. L'uniformité du champ magnétique à l'intérieur de l'entrefer 5 est assurée par deux pièces polaires 2 et 2' en matériau perméable magnétique et disposées respectivement sur les faces 20 et 20', de polarités opposées, des aimants permanents principaux 1 et 1' donnant sur l'entrefer 5. Toutefois, dans les conceptions de l'art antérieur, les pièces polaires 2 et 2' recouvrent entièrement les faces 20 et 20' selon le contour 4. Dans les réalisations d'après l'invention, les pièces polaires sont au contraire moins larges que les aimants permanents principaux 1 et 1' qu'elles recouvrent et ont le contour 4'.

Le dispositif comprend également une culasse 3 en matériau perméable magnétique qui assure la fermeture des lignes de champ magnétique de l'aimant permanent 1' à l'aimant permanent principal 1. Elle se compose de deux parois de support 21 et 21' sur la surface intérieure desquelles les aimants permanents principaux 1 et 1' sont disposés et qui sont reliées par deux parois de liaison 22 et 22'. Ici on a représenté, ce qui est une réalisation courante mais non obligatoire, la culasse 3 de section rectangulaire, les aimants permanents principaux 1 et 1' parallélépipédiques et les pièces polaires 2 et 2' d'épaisseur constante ; l'entrefer 5 a donc également une forme parallélépipédique.

Comme la section de la culasse 3 est fermée, les fuites d'énergie magnétique sont peu importantes. Mais la cartographie du champ magnétique révèle que, dans les réalisations de l'art antérieur ne comprenant que les éléments décrits jusqu'ici, certaines lignes de champ 7 et 7' sont déviées par les parois de liaison 22 et 22' de la culasse 3 et relient directement celles-ci aux aimants permanents principaux, respectivement 1 et 1', sans passer par l'autre aimant permanent principal, respectivement 1' et 1. Il en résulte que le champ magnétique dans l'entrefer 5 est affaibli et que son homogénéité est perturbée, car l'affaiblissement est surtout marqué à sa périphérie.

C'est pourquoi on dispose deux aimants permanents additionnels ou latéraux 6 et 6', ici également de forme parallélépipédique, dont le sens d'aimantation est inverse de celui des aimants permanents principaux 1 et 1', face aux parois de liaison 22 et 22', et à la périphérie de l'entrefer 5 et des pièces polaires 2 et 2'. Leur action est plus efficace si les aimants permanents principaux 1 et 1' débordent des pièces polaires 2 et 2' en direction des parois de liaison 22 et 22' ; de même si les aimants permanents latéraux 6 et 6' débordent des pièces polaires 2 et 2' en direction des parois de liaison 22 et 22'.

Selon l'invention, les aimants permanents latéraux 6 et 6' sont introduits entre les pièces polaires 2 et 2' et les aimants permanents principaux 1 et 1' de façon à venir en regard des bords latéraux référencés 25, 26 et 25', 26' pour les pièces polaires 2 et 2' et 27, 28 et 27', 28' pour les aimants permanents principaux 1 et 1'. La hauteur des aimants permanents latéraux 6 et 6' est moindre que la largeur de l'entrefer 5, ce qui permet de les y introduire avec un jeu réduit et de régler éventuellement leur position latérale ou verticale par rapport aux pièces polaires 2 et 2'.

On constate alors plusieurs phénomènes.

Les aimants permanents latéraux 6 et 6' contribuent tout d'abord à isoler l'entrefer 5 de la culasse 3 : les lignes de champ magnétique 8 provenant des aimants permanents principaux 1 et 1' sont désormais incurvées vers le centre de l'entrefer 5. On peut donc en déduire que l'énergie magnétique perdue à cause de la proximité des parois de liaison 22 et 22' est réduite. Elle l'est encore davantage si les aimants permanents principaux 1 et 1' et/ou latéraux 6 et 6' débordent des pièces polaires 2 et 2' en direction des parois de liaison 22 et 22'.

En outre, les aimants permanents latéraux 6 et 6' contribuent par eux-mêmes au renforcement du champ magnétique dans l'entrefer 5 par leurs lignes de champ 9.

Des essais ont par ailleurs montré que l'homogénéité du champ magnétique reste très bonne. Mais il est possible de l'améliorer par le réglage de la position des aimants permanents latéraux 6 et 6'.

A cet effet, ils sont chacun en contact avec des extrémités de vis de réglage 15, 15', 16 et 16' de préférence en matériau non magnétique : les vis verticales 15 et 15' s'adaptent dans des taraudages traversant de part en part les parois de support 21 et 21' respectivement, les vis latérales 16 et 16' s'adaptent dans des taraudages traversant de part en part les parois de liaison 22 et 22' respectivement. Les têtes de toutes ces vis sont à l'extérieur de la culasse 3.

Les aimants latéraux 6 et 6' sont coincés entre des vis verticales 15 et 15' opposées qui permettent donc de faire varier les jeux entre les aimants permanents latéraux 6 et 6' et les pièces polaires 2 et 2'. Leur position latérale , c'est-à-dire la largeur de l'entrefer 5, peut être modifiée en agissant sur les vis latérales 16 et 16' respectivement.

Bien d'autres dispositifs mécaniques peuvent évidemment assurer de façon satisfaisante le réglage de la position des aimants permanents latéraux 6 et 6' afin d'améliorer l'homogénéité du champ magnétique, surtout aux bords de l'entrefer 5, près de ces aimants permanents latéraux 6 et 6'.

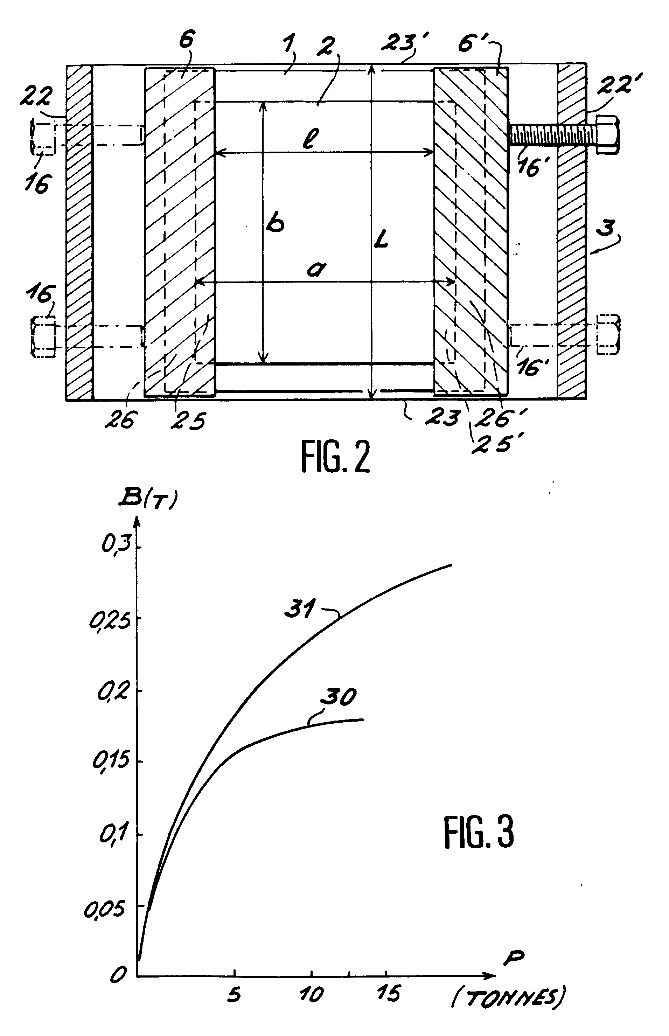

La figure 2 donne une vue complémentaire du dispositif selon l'invention. Elle permet de constater qu'il n'est pas nécessaire de refermer la culasse 3 en ajoutant de la matière magnétique à ses deux extrémités 23 et 23' pour limiter les pertes d'énergie magnétique vers l'extérieur, ce qui est le cas de dispositifs connus dans l'imagerie médicale où on ne laisse qu'une ouverture étroite pour laisser passer le malade dans l'entrefer 5 : on dispose ici d'un champ magnétique d'intensité suffisante, ce qui permet d'adopter une conception plus légère.

Il est encore avantageux de faire déborder les aimants permanents latéraux 6 et 6' et principaux 1 et 1' des pièces polaires 2 et 2' également dans le sens de la longueur de la culasse 3 (L), pour les raisons concernant la limitation des pertes magnétiques qui ont été indiquées lors de la description de la figure 1.

Sur la figure 3, à titre d'exemple, on a porté en abscisse le poids total en tonnes des aimants permanents du type ferrite, des pièces polaires et de la culasse d'une installation, et en ordonnée le champ magnétique en teslas engendré dans l'entrefer. La courbe 30 correspond à diverses configurations d'une installation sans aimants permanents latéraux 6 et 6' ; la courbe 31 correspond aux mêmes configurations d'une installation comportant en outre ces aimants permanents latéraux 6 et 6'. Il est clair que l'alourdissement impliqué est plus que compensé par l'augmentation du champ magnétique que l'on enregistre.

D'autres essais ont démontré que l'augmentation du débordement des aimants permanents par rapport aux pièces polaires 2 et 2' pourrait ajouter plusieurs dixièmes de tesla à l'intensité du champ magnétique.

Le tableau I fournit quelques exemples de réalisations possibles avec du matériau de type ferrite. Les symboles utilisés se retrouvent sur les figures 1 et 2.

TABLEAU 1

| Hauteur de l'entrefer (h, en m) | 0,5 | 0,5 | 0,5 |
|---|---|---|---|
| Largeur de l'entrefer (l, en m) | 0,75 | 0,75 | 0,75 |
| Largeur des pièces polaires (a, en m) | 1,25 | 1,25 | 1,25 |
| Longueur des pièces polaires (b, en m) | 1,375 | 1,40 | 1,25 |
| Longueur de la culasse (L, en m) | 1,62 | 1,62 | 2,00 |
| Volume dans la culasse ($m^3$) | 5,8 | 6,2 | 8,6 |
| Poids de l'installation (t) | 20 | 25 | 35 |
| Champ magnétique (T) | 0,25 | 0,275 | 0,3 |
| Volume des aimants permanents ($m^3$) | 2,2 | 2,8 | 4,2 |
| Poids des aimants permanents (t) | 11 | 14 | 21 |

La variation relative du champ magnétique est d'environ $10^{-4}$ sur la largeur de l'entrefer 5 (entre les aimants permanents latéraux 6 et 6') et $3.10^{-4}$ sur sa longueur et sa hauteur.

L'invention fournit donc une solution intéressante pour la construction de générateurs de champs magnétiques intenses nécessaires notamment dans l'imagerie par résonance magnétique ; le meilleur emploi de la matière magnétique peut se traduire soit par un accroissement de l'intensité du champ, soit par un allègement de l'installation.

**Revendications**

1. Système d'aimants permanents comportant une culasse perméable magnétique (3) formée de deux parois de support (21, 21') opposées et reliées par deux parois de liaison (22, 22'), deux aimants permanents principaux (1, 1') de même sens d'aimantation disposés sur les parois de support (21, 21') à l'intérieur de la culasse (3) et dont des faces en regard (20, 20') portent des pôles opposés, deux plaques (2, 2') perméables magnétiques sur les faces en regard (20, 20') et qui délimitent un entrefer (5), deux aimants permanents latéraux (6, 6') de sens d'aimantation opposé à celui des aimants permanents principaux (1, 1'), qui délimitent également l'entrefer (5) et qui sont disposés en face des parois de liaison (22, 22') et à l'intérieur de la culasse (3), caractérisé en ce que les aimants permanents latéraux (6, 6') s'étendent latéralement entre les plaques (2, 2') perméables magnétiques de façon à venir en regard des bords latéraux des aimants permanents principaux (1, 1') et des plaques (2, 2') perméables magnétiques, et en ce que les aimants permanents principaux (1, 1') débordent des plaques (2, 2').

2. Système d'aimants permanents suivant la revendication 1, caractérisé en ce que les parois de support sont horizontales, les parois de liaison verticales, les aimants permanents principaux et latéraux sont des parallélépipèdes, et l'entrefer a une forme parallélépipédique et est ouvert sur deux côtés opposés (23, 23').

3. Système d'aimants permanents suivant l'une quelconque des revendications 1 ou 2, caractérisé en ce que les aimants permanents latéraux (6,6') débordent des plaques (2, 2').

4. Système d'aimants permanents suivant l'une quelconque des revendications 1 à 3, caractérisé en ce qu'il comprend des moyens mécaniques (15, 16) pour faire varier la position des aimants permanents latéraux (6, 6') par rapport aux plaques (2, 2').

**Claims**

1. System of permanent magnets having a permeable magnetic yoke (3) formed by two opposite support walls (21, 21') and connected by two connecting walls (22, 22'), two main permanent magnets (1, 1') of the same magnetization direction disposed on the support walls (21, 21') within the yoke (3) and whereof the facing surfaces (20, 20') carry opposite poles, two permeable magnetic plates (2, 2') on the facing surfaces (20, 20') and which define an air gap (5) and two lateral permanent magnets (6, 6') whose magnetization direction is opposite to that of the main permanent magnets (1, 1') and which also define the air gap (5), being positioned facing the connecting walls (22, 22') and within the yoke (3), characterized in that the lateral permanent magnets (6, 6') extend laterally between the permeable magnetic plates (2, 2'), so as to be positioned facing the lateral edges of the main permanent magnets (1, 1') and the permeable magnetic plates (2, 2') and that the main permanent magnets (1, 1') project over plates (2, 2').

2. System of permanent magnets according to claim 1, characterized in that the support walls are horizontal, the connecting walls vertical, the main and lateral permanent magnets parallelepipedic and the air gap parallelepipedic and open on two opposite sides (23, 23').

3. System of permanent magnets according to either of the claims 1 and 2, characterized in that the lateral permanent magnets (6, 6') project over plates (2, 2').

4. System of permanent magnets according to any one of the claims 1 to 3, characterized in that it comprises mechanical means (15, 16) for varying the position of the lateral permanent magnets (6, 6') with respect to the plates (2, 2').

**Patentansprüche**

1. Permanentmagnetsystem, enthaltend ein permeables Magnetjoch (3), das aus zwei Tragwänden (21, 21') gebildet ist, die einander gegenüberstehen und durch zwei Bindungswände (22, 22') miteinander verbunden sind, zwei Hauptpermanentmagnete (1, 1') gleicher Magnetisierungsrichtung, die auf den Tragwänden (21, 21') im Innern des Jochs (3) angeordnet sind und deren einander gegenüberstehende Flächen (20, 20') entgegengesetzte Pole tragen, zwei permeable Magnetplatten (2, 2') auf den einander gegenüberliegenden Flächen (20, 20'), die einen Zwischenraum (5) begrenzen, zwei seitliche Permanentmagnete (6, 6') einer Magnetisierung, die entgegengesetzt zu der der Hauptpermanentmagnete (1, 1') ist und die ebenfalls den Zwischenraum (5) begrenzen und die den Verbindungswänden (22, 22') gegenüberliegend und im Innern des Jochs (3) angeordnet sind, dadurch gekennzeichnet, daß die seitlichen Permanentmagnete (6, 6') sich seitlich zwischen den permeablen Magnetplatten (2, 2') derart erstrecken, daß sie den seitlichen Begrenzungen der Hauptpermanentmagnete (1, 1') und der permeablen Magnetplatten (2,2') gegenüberstehen und daß die Hauptpermanentmagnete (1, 1') über die Platten (2, 2') hinausragen.

2. Permanentmagnetsystem nach Anspruch 1, dadurch gekennzeichnet, daß die Tragwände horizontal sind, die Verbindungswände vertikal sind, die Hauptpermanentmagnete und die seitlichen Permanentmagnete quaderförmig sind und der Zwischenraum eine quaderförmige Gestalt hat und an zwei gegenüberliegenden Seiten (23, 23') offen ist.

3. Permanentmagnetsystem nach einem der Ansprüche 1 oder 2, dadurch gekennzeichnet, daß die seitlichen Permanentmagnete (6, 6') über die Platten (2, 2') hinausragen.

4. Permanentmagnetsystem nach einem der Ansprüche 1 bis 3, dadurch gekennzeichnet, daß es mechanische Einrichtungen (15, 16) aufweist, um die Position der seitlichen Permanentmagnete (6, 6') gegenüber den Platten (2, 2') zu verändern.

FIG. 1

FIG. 2

FIG. 3